# EUROPÄISCHE PATENTSCHRIFT

(11) **EP 2 770 641 B1**
(45) Veröffentlichungstag und Bekanntmachung des Hinweises auf die Patenterteilung: **29.04.2020**
(21) Anmeldenummer: 14305186.0
(22) Anmeldetag: 13.02.2014
(51) Int. Cl.: H03M 1/50, G01R 19/25, G01R 19/255, H03M 1/08, H03M 1/12

(54) **Vorrichtung zur Auswertung von elektrischen Eingangssignalen**
Device for the evaluation of electrical input signals
Dispositif d'exploitation de signaux d'entrée électriques

(30) Priorität: 20.02.2013 DE 102013202788
(43) Veröffentlichungstag der Anmeldung: 27.08.2014
(73) Patentinhaber: Schneider Electric Industries SAS, 92500 Rueil-Malmaison (FR)
(72) Erfinder: Bogie, Wolfgang, 93053 Regensburg (DE); Zeller, Franz, 85101 Lenting (DE); Millaud, Eric, 30250 Villevieille (FR); Brown, Paul, Staffordshire, ST5 6SX (GB)
(74) Vertreter: Manitz Finsterwald Patent- und Rechtsanwaltspartnerschaft mbB

(56) Entgegenhaltungen:
- EP-A2- 2 348 326
- JP-A- H10 332 747
- US-B1- 6 181 587

## Beschreibung

Die Erfindung betrifft eine Vorrichtung zur Auswertung von elektrischen Eingangssignalen, insbesondere in einer Schaltanlage für die Mittel- oder Hochspannungstechnik.

Aus der EP 2 348 326 A2 ist eine Vorrichtung gemäß dem Oberbegriff des Anspruchs 1 bekannt. Die US 6 181 587 B1 offenbart eine Spannungserfassungsvorrichtung für drei Phasen, bei welcher ein Eingangssignal in ein gepulstes Signal übersetzt wird, wobei die Breite der Pulse von der Spannungsamplitude des Eingangssignals abhängt. Die JP H10 332747 A beschreibt eine Druckmessschaltung, welche ein Spannungssignal ausgibt.

Schaltanlagen für die Mittel- oder Hochspannungstechnik dienen zur Verteilung und/oder Umspannung elektrischer Energie in einem elektrischen Energieversorgungsnetz. Eine Schaltanlage umfasst typischerweise ein oder mehrere Schaltfelder, zum Beispiel ein oder mehrere Abgangsfelder und/oder Transformatorfelder, die jeweils eine Übertragungs- bzw. Verteilerleitung mit einer weiteren Übertragungs- oder Verteilerleitung schaltbar und/oder umspannend verbinden. Ein Schaltfeld umfasst dazu ein oder mehrere primärtechnische Mittel, worunter Schaltgeräte wie zum Beispiel Leistungsschalter, Trennschalter oder Erdungsschalter verstanden werden sowie Stromwandler und Spannungswandler.

Zur Steuerung und Überwachung der Schaltfelder kann ein Steuerungssystem vorgesehen sein, welches ein oder mehrere jeweils einem Schaltfeld zugeordnete Feldgeräte umfasst, die Steuer-, Melde- und Überwachungsfunktionen in Bezug auf die primärtechnischen Mittel des jeweiligen Schaltfelds bereitstellen und die z.B. über ein Bussystem mit einer übergeordneten Steuerung kommunizieren. Ein Feldgerät kann, insbesondere analoge, Meldesignale oder andere analoge oder digitale Signale empfangen, die von dem Schaltfeld zur Unterstützung der Steuer- und Überwachungsfunktionen erzeugt werden und die z.B. eine Information über den Schaltzustand eines Schaltgeräts enthalten können. Diese Signale werden von entsprechenden Signalgebern der Schaltfelder unter Verwendung einer Versorgungsspannung generiert, welche eine Hilfsspannung darstellt, die von der Mittel- oder Hochspannung unabhängig ist, die von dem Schaltfeld geschaltet bzw. umgespannt wird und die eine Niederspannung sein kann. Die in verschiedenen Schaltfeldern genutzten Hilfsspannungen können sich sowohl im Hinblick auf ihre Art, d.h. ihre Eigenschaft als Gleich- oder Wechselspannung, als auch im Hinblick auf ihren Betrag modell- oder einsatzabhängig deutlich voneinander unterscheiden. Dementsprechend unterscheiden sich auch die unter Verwendung der Hilfsspannung generierten Meldesignale, die von den Feldgeräten ausgewertet werden sollen, im Hinblick auf ihre Art und auf ihre maximale Signalamplitude.

Ein Feldgerät weist typischerweise eine Vorrichtung auf, welche dazu eingerichtet ist, die Information, die in einem von einem Schaltfeld erzeugten Meldesignal enthalten ist und die durch die Spannungsamplitude des Signals repräsentiert sein kann, auszuwerten und in einen digitalen Wert umzuwandeln, der im Rahmen der Überwachungs- und Steuerungsfunktionen verwendet wird. Derartige Vorrichtungen weisen mehrere Kanäle zum Empfangen mehrerer Eingangssignale auf, die von der Vorrichtung ausgewertet werden.

Nachteilig bei bekannten Auswertevorrichtungen dieser Art ist, dass diese typischerweise nur für Gleichspannungssignale und nur für einen eng vorgegebenen Bereich von Spannungsamplituden der Eingangssignale verwendbar sind, so dass eine Auswertevorrichtung nur mit bestimmten Schaltfeldern einsetzbar ist. Die bekannten Vorrichtungen lassen sich z.B. nicht gleichermaßen für Gleich- und Wechselspannungssignale verwenden oder für Eingangssignale, deren maximale Spannungsamplituden zwischen 20 und 300 Volt variieren. Es ist auch nicht mit vertretbarem Aufwand möglich, die bekannten Vorrichtungen, z.B. mit herkömmlichen Methoden der Analog-Digital-Wandlung, so umzugestalten, dass diese ein derartiges Spektrum von Eingangssignalen verarbeiten können. Dabei stellt sich unter anderem die Schwierigkeit, die zum Empfangen und Vorverarbeiten der Eingangssignale vorgesehenen Kanäle galvanisch voneinander und von dem die Digitalisierung durchführenden Mikroprozessor zu trennen.

Aufgabe der Erfindung ist es daher, eine Vorrichtung zur Auswertung von elektrischen Eingangssignalen, insbesondere in einer Schaltanlage für die Mittel- oder Hochspannungstechnik, mit mehreren Kanälen zu schaffen, die ein breites Spektrum von Eingangssignalen auswerten kann und die gleichzeitig einfach aufgebaut und kostengünstig herstellbar ist. Ferner soll die Vorrichtung eine galvanische Trennung zwischen den Kanälen und dem Mikroprozessor ermöglichen, der die digitale Auswertung durchführt.

Die Aufgabe wird durch eine Vorrichtung mit den Merkmalen des Anspruchs 1 gelöst.

Die Vorrichtung ist zur Auswertung von elektrischen Eingangssignalen, insbesondere in einer Schaltanlage für die Mittel- oder Hochspannungstechnik, ausgebildet und weist mehrere Kanäle auf, wobei jeder Kanal umfasst:
- einen Eingang zum Empfangen eines elektrischen Eingangssignals, und
- eine Signalverarbeitungseinrichtung, die dazu ausgebildet ist, aus dem Eingangssignal oder aus einem von dem Eingangssignal abgeleiteten Signal ein gepulstes elektrisches Signal mit wenigstens einem Puls zu erzeugen, wobei die Breite des wenigstens einen Pulses von der Spannungsamplitude des Eingangssignals abhängt.
Die Vorrichtung umfasst ferner einen gemeinsamen Mikroprozessor, der dazu ausgebildet ist, die gepulsten Signale der Kanäle oder von den gepulsten Signalen abgeleitete Signale der Kanäle zu empfangen und durch Auswerten einer jeweiligen Pulsbreite der empfangenen Signale einen digitalen Wert zu erzeugen, welcher der Spannungsamplitude des Eingangssignals des jeweiligen Kanals entspricht.

Erfindungsgemäß wurde erkannt, dass es unabhängig von der Art und der maximalen Spannungsamplitude eines elektrischen Eingangssignals mit sehr einfachen Mitteln möglich ist, das Eingangssignal in ein gepulstes Signal umzuwandeln, dessen Pulsbreite der Spannungsamplitude des Eingangssignals entspricht. Anhand eines solchen gepulsten Signals lässt sich durch einen Mikroprozessor ein der Spannungsamplitude des Eingangssignals entsprechender digitaler Wert erzeugen, ohne dass eine aufwendige herkömmliche A/D-Wandlung notwendig ist, da der Mikroprozessor dazu lediglich die Pulsbreite des gepulsten Signals digital ermitteln muss. Der gemeinsame Mikroprozessor kann z.B. programmierbar sein und kann ohne weiteres eine Vielzahl von gepulsten Signalen parallel auswerten, so dass die Vorrichtung äußerst kostengünstig und auf geringem Bauraum realisierbar ist. Das gepulste Signal eignet sich zur nicht-galvanischen Signalübertragung zu dem gemeinsamen Mikroprozessor, so dass eine zuverlässige galvanische Trennung zwischen den Kanälen und dem Mikroprozessor realisierbar ist.

Vorteilhafte Ausführungsformen der Erfindung sind in der Beschreibung, den Unteransprüchen und den Figuren beschrieben.

Gemäß einer bevorzugten Ausführungsform umfasst zumindest ein Kanal und insbesondere jeder Kanal eine Gleichrichterschaltung zur Erzeugung eines gleichgerichteten Signals aus dem Eingangssignal des Kanals oder aus einem von dem Eingangssignal abgeleiteten Signal des Kanals. Durch die Gleichrichtung wird ein bipolares Eingangssignal, insbesondere ein Wechselspannungssignal, in ein unipolares Signal, insbesondere ein Gleichspannungssignal, umgewandelt. Die Spannungsamplitude des gleichgerichteten unipolaren Signals kann in einem festen, zum Beispiel proportionalen, Zusammenhang mit der Spannungsamplitude des bipolaren Signals stehen. Dadurch wird die nachfolgende Signalverarbeitung erheblich vereinfacht, da sich aus einem unipolaren Signal in besonders einfacher Weise ein gepulstes Signal erzeugen lässt, dessen Pulsbreite von der Spannungsamplitude des unipolaren Signals abhängt. Die Vorrichtung kann einen Kondensator, insbesondere einen Glättungskondensator, umfassen, der mit der Gleichrichterschaltung verbunden ist, um das gleichgerichtete Signal zu glätten, wodurch die nachfolgende Signalverarbeitung noch weiter vereinfacht wird.

Die Vorrichtung kann eine Schutzbeschaltung aufweisen, um die Vorrichtung vor Überspannungen und/oder Überströmen zu schützen. Die Schutzbeschaltung kann beispielsweise ein Überspannungsschutzelement wie z.B. einen Varistor umfassen, welches mit den beiden Anschlüssen verbunden ist, die den Eingang für das Eingangssignal bilden und welches bei einem Spannungswert oberhalb eines zulässigen Schwellwerts eine Ableitung des elektrischen Stroms von dem einen Anschluss zu dem anderen Anschluss bewirkt. Die Schutzbeschaltung kann ein Überstromschutzelement wie z.B. einen PTC-Widerstand aufweisen, welcher von dem in den Kanal eingespeisten Strom durchflossen ist und seinen Widerstand bei einem Stromwert oberhalb eines Schwellwerts so erhöht, dass der Strom beschränkt wird. Die Schutzbeschaltung kann unmittelbar an dem Eingang der Vorrichtung vorgesehen sein. Die Schutzbeschaltung kann auch ganz oder teilweise zwischen einer Gleichrichterschaltung und der Signalverarbeitungseinrichtung des jeweiligen Kanals angeordnet sein.

Gemäß einer Ausführungsform weist zumindest ein Kanal und insbesondere jeder Kanal eine Skalierungsschaltung zur Erzeugung eines skalierten Signals aus dem Eingangssignal des Kanals oder aus einem von dem Eingangssignal abgeleiteten Signal des Kanals auf. Das Signal kann so skaliert werden, dass das skalierte Signal in der Signalverarbeitungseinrichtung, welche insbesondere einen Mikroprozessor umfassen kann, auswertbar ist. Die Skalierungsschaltung kann beispielsweise einen Spannungsteiler umfassen.

Vorzugsweise wird das Signal mit einem Skalierungsfaktor skaliert, welcher weniger als 1, bevorzugt höchstens 1/20, ferner bevorzugt höchstens 1/30, besonders bevorzugt höchstens 1/50 und höchst bevorzugt höchstens 1/100 beträgt. Die Vorrichtung kann prinzipiell zur Auswertung von Eingangssignalen ausgebildet sein, deren maximale Spannungsamplitude zwischen 20 und 300 Volt bei Gleichspannung und/oder zwischen 20 und 230 Volt bei Wechselspannung beträgt. Durch die vorstehend genannten Skalierungsfaktoren können diese Spannungsamplituden auf einen Wert reduziert werden, welcher z.B. für Mikroprozessoren zulässig ist. Bei Verwendung eines Spannungsteilers kann ein solcher Skalierungsfaktor durch eine entsprechende Wahl des Verhältnisses der den Spannungsteiler bildenden elektrischen Widerstände realisiert werden. Zwischen den beiden Anschlüssen, zwischen denen die skalierte Spannung bereitgestellt wird, kann ein Kondensator zur Glättung angeschlossen sein, um eine skalierte und geglättete Spannung zu erzeugen.

Erfindungsgemäß weist zumindest ein Kanal und insbesondere jeder Kanal eine Stromversorgungsschaltung auf, die dazu eingerichtet ist, aus dem Eingangssignal des Kanals oder aus einem von dem Eingangssignal abgeleiteten Signal des Kanals zumindest ein Gleichspannungssignal mit einer vorzugsweise zumindest näherungsweise konstanten Spannung zur Stromversorgung von Komponenten des Kanals zu erzeugen. Die Vorrichtung kann so ausgebildet sein, dass sich der jeweilige Kanal aus dem jeweiligen Eingangssignal vollständig selbst mit elektrischer Leistung versorgt. Diese Selbstversorgung ermöglicht es, auf eine separate Stromversorgung für den Kanal zu verzichten, wodurch eine galvanische Isolierung des Kanals vereinfacht wird. Die Stromversorgungsschaltung eines Kanals und insbesondere der gesamte Kanal können dementsprechend als passive elektrische bzw. elektronische Schaltung ausgebildet sein.

Die Stromversorgungsschaltung kann eine oder mehrere Schaltungen zur Spannungsstabilisierung, wie z.B. einen oder mehrere Spannungsregler, umfassen. Eine solche Schaltung kann zum Beispiel eine Zenerdiode umfassen, deren Durchbruchspannung als Spannungsreferenz für die Spannungsstabilisation verwendet wird. Die Kathode der Zenerdiode kann mit der Basis eines insbesondere bipolaren Transistors und über einen Vorwiderstand mit dem Kollektor des Transistors verbunden sein, dessen Emitter die stabilisierte Spannung bereitstellt. An dem Emitter des Transistors kann ein Kondensator zur Glättung angeordnet sein. Es können mehrere derartige Schaltungen hintereinander geschaltet sein, die jeweils eine von verschiedenen Gleichspannungen erzeugen. Eine Spannung kann dabei als Versorgungsspannung dienen und eine andere Spannung, wie nachstehend noch erläutert, als Kontroll- bzw. Überprüfungsspannung. Die Versorgungsspannung kann zum Beispiel zwischen 3 und 7 Volt und insbesondere zumindest näherungsweise 5 Volt betragen.

Die Signalverarbeitungseinrichtung erzeugt aus dem Eingangssignal des Kanals bzw. aus einem davon abgeleiteten Signal ein gepulstes Signal mit zumindest einem und vorzugsweise mehreren Pulsen. Vorzugsweise handelt es sich bei dem gepulsten Signal um ein unipolares und/oder binärwertiges Spannungssignal, insbesondere mit senkrechten, jeweils einen Puls begrenzenden steigenden und fallenden Flanken. Ein binärwertiges Signal weist abgesehen von den vorzugsweise zumindest näherungsweise "senkrechten", das heißt nur einen sehr kurzen Zeitraum einnehmenden, Flanken einen zumindest näherungsweise konstanten Signalpegel auf, welcher entweder einen hohen Wert ("high") oder einen niedrigen Wert ("low") annimmt. Ein solches Signal ist durch den gemeinsamen Mikroprozessor besonders zuverlässig und robust auswertbar.

Gemäß einer Ausführungsform ist die Signalverarbeitungseinrichtung zumindest eines Kanals und insbesondere jedes Kanals dazu eingerichtet, aus dem Eingangssignal des Kanals oder aus einem von dem Eingangssignal abgeleiteten Signal des Kanals ein pulsweitenmoduliertes Signal zu erzeugen, wobei die Pulsbreite des pulsweitenmodulierten Signals von der Spannungsamplitude des Eingangssignals abhängt. Eine solche Pulsweitenmodulation stellt eine mit einfachen und kostengünstig verfügbaren Mitteln zu bewerkstelligende Maßnahme dar, um das Eingangssignal in ein gepulstes Signal mit einer der Spannungsamplitude des Eingangssignals entsprechenden Pulsbreite umzuwandeln. Das pulsweitenmodulierte Signal kann dabei eine zumindest näherungsweise konstante Tastperiode aufweisen, wobei in einer Tastperiode vorzugsweise genau ein Puls mit einer vorgegebenen Breite vorhanden ist und wobei das Verhältnis aus Pulsbreite und Periodendauer das Tastverhältnis des pulsweitenmodulierten Signals definiert.

Die Pulsbreite des gepulsten bzw. pulsweitenmodulierten Signals kann in einer besonders einfachen Ausführungsform zumindest näherungsweise proportional zu der Spannungsamplitude des Eingangssignals oder eines von dem Eingangssignal abgeleiteten Signals des Kanals sein.

Bevorzugt umfasst die Signalverarbeitungseinrichtung zumindest eines Kanals und insbesondere jedes Kanals einen weiteren dem Kanal zugeordneten Mikroprozessor. Das Eingangssignal bzw. das davon abgeleitete Signal kann dabei an einem analogen Eingang des Mikroprozessors anliegen. Bei dem Mikroprozessor kann es sich insbesondere um einen programmierbaren Mikroprozessor handeln. Ein Mikroprozessor ist besonders dazu geeignet, das gepulste Signal gemäß der vorliegenden Beschreibung zu erzeugen. Der Mikroprozessor kann einen Stromversorgungseingang aufweisen, der mit der vorstehend beschriebenen Stromversorgungsschaltung verbunden ist, um den Mikroprozessor aus dem Eingangssignal mit elektrischer Leistung zu versorgen.

Die Signalverarbeitungseinrichtung kann eine Zeitbasis wie z.B. den Takt eines Taktgebers eines Mikroprozessors nutzen, um das gepulste Signal zu erzeugen. Unter Verwendung der Zeitbasis kann eine Referenzspannung in regelmäßigen Zeitabständen stufenweise erhöht oder verringert werden und in jedem Schritt überprüft werden, ob die Spannung des Eingangssignals oder des davon abgeleiteten Signals die Referenzspannung über- bzw. unterschreitet. Die Signalverarbeitungseinrichtung kann so lange einen Puls senden bzw. einen entsprechenden Signalwert bzw. - pegel an ihrem Ausgang bereitstellen, bis die Eingangsspannung den Referenzwert erstmalig über- bzw. unterschreitet, woraufhin der Puls beendet werden kann. In regelmäßigen Zeitabständen, beispielsweise am Ende jeder Tastperiode, kann die Referenzspannung dann zurückgesetzt werden, um den nächsten Puls zu erzeugen. Die Erzeugung des gepulsten Signals stellt nur sehr geringe Anforderungen an die Signalverarbeitungseinrichtung und kann mit hoher Genauigkeit und Zuverlässigkeit erfolgen.

Gemäß einer vorteilhaften Ausführungsform ist zumindest ein Kanal und insbesondere jeder Kanal dazu eingerichtet, die Spannung des Eingangssignals des Kanals oder die Spannung eines von dem Eingangssignal abgeleiteten Signals des Kanals mit einem vorgegebenen Schwellwert zu vergleichen. Die Erzeugung des gepulsten Signals des Kanals unterbleibt dabei vorzugsweise, wenn die Spannung den Schwellwert unterschreitet. Der Schwellwert ist vorzugsweise einstellbar, insbesondere individuell für jeden Kanal. Zur Durchführung des Schwellwertvergleichs kann eine Schwellwertschaltung vorgesehen sein.

Durch den Schwellwertvergleich können Eingangssignale mit niedrigen Amplituden, die insbesondere zwischen einer zulässigen niedrigen und einer zulässigen hohen Amplitude liegen, auf ein Signal mit einer zulässigen Amplitude von z.B. dauerhaft 0 Volt umgesetzt werden, wodurch die Robustheit der Auswertung erhöht wird. Die Einstellbarkeit des Schwellwerts ermöglicht es, die Schwellwertüberprüfung an die von dem jeweiligen Kanal erwarteten zulässigen Amplituden anzupassen. Der Schwellwertvergleich kann beispielsweise dadurch erfolgen, dass die jeweilige Spannung, ggf. nach einer Skalierung, mit einer den Schwellwert repräsentierenden Spannungsreferenz verglichen wird.

Der Schwellwertvergleich kann dazu dienen, undefinierte Zustände des Kanals und der erzeugten Signale zu vermeiden. Dies ist insbesondere relevant, wenn der Kanal bzw. dessen Komponenten wie vorstehend beschrieben ganz oder teilweise aus dem Eingangssignal der Vorrichtung mit Strom versorgt werden. Ein zu geringer Wert der Eingangsspannung kann dann zu einer zu geringen aus der Eingangsspannung abgeleiteten Versorgungsspannung führen, so dass ein definiertes Verhalten der Komponenten nicht mehr unter allen Umständen gewährleistet ist.

Um dies zu vermeiden kann die Stromversorgungsschaltung, wie vorstehend beschrieben, eine Kontrollspannung aus dem Eingangssignal erzeugen, welche insbesondere etwas höher sein kann als die durch die Stromversorgungsschaltung erzeugte Versorgungsspannung. Die Kontrollspannung kann durch eine Schwellwertschaltung mit einem Schwellwert verglichen werden, der so angepasst ist, dass oberhalb des Schwellwerts eine ausreichend hohe Versorgungsspannung für alle mit der Versorgungsspannung versorgten Komponenten des Kanals gewährleistet ist. Die Schwellwertschaltung kann dazu eingerichtet sein, bei Unterschreiten des Schwellwerts durch die Kontrollspannung ein Ausgangssignal an einen Eingang der Signalverarbeitungseinrichtung zu senden, welches der Signalverarbeitungseinrichtung anzeigt, dass ein Unterschreiten der zulässigen Versorgungsspannung eingetreten ist oder einzutreten droht. Daraufhin kann die Signalverarbeitungseinrichtung einen definierten Haltezustand einnehmen, in dem z.B. die Erzeugung des gepulsten Signals unterbleibt und der entsprechende Signalausgang z.B. abgeschaltet wird.

Die Schwellwertschaltung kann einen, insbesondere integrierten, Schaltkreis mit einem Eingang für die Kontrollspannung bzw. für eine davon abgeleitete Spannung aufweisen. Der Schaltkreis kann mit einem oder mehreren Kalibrierungswiderständen beschaltet sein, von deren Wert der Schwellwert, mit dem die Kontrollspannung verglichen wird, abhängig ist, so dass der Schwellwert durch entsprechende Wahl der Widerstände, insbesondere vor der Inbetriebnahme der Vorrichtung, einstellbar ist.

Die Stromversorgungsschaltung kann dazu eingerichtet sein, bei einer zulässigen Spannungsamplitude des Eingangssignals, welche insbesondere zwischen 20 und 300 Volt liegen kann, eine Kontrollspannung von z.B. etwa 12 Volt zu erzeugen. Die Kontrollspannung kann mit einem Schwellwert von z.B. etwa 10 Volt verglichen werden.

Gemäß einer vorteilhaften Ausführungsform sind zwischen zumindest einem Kanal und dem gemeinsamen Mikroprozessor Mittel zur nicht-galvanischen Übertragung des gepulsten Signals des Kanals oder eines von dem gepulsten Signal abgeleiteten Signals des Kanals zu dem gemeinsamen Mikroprozessor vorgesehen. Dadurch kann eine galvanische Trennung zwischen dem Kanal und dem gemeinsamen Mikroprozessor sowie den nachgeschalteten Komponenten realisiert werden. Die Mittel zur nicht-galvanischen Signalübertragung können Mittel zur optischen, induktiven und/oder kapazitiven Signalübertragung und insbesondere wenigstens einen Optokoppler umfassen.

Das durch die Signalverarbeitungseinrichtung erzeugte gepulste Signal lässt sich in sehr einfacher Weise nicht-galvanisch übertragen, so dass die galvanische Entkopplung besonders einfach möglich ist und gleichzeitig eine zuverlässige Signalübertragung und Signalauswertung gewährleistet wird. Vorzugsweise ist zumindest ein Kanal und insbesondere jeder Kanal vollständig galvanisch von dem Schaltkreis getrennt, der den gemeinsamen Mikroprozessor umfasst. Zudem können zumindest zwei und insbesondere alle Kanäle voneinander bzw. von allen anderen Kanälen galvanisch getrennt sein, wodurch die Sicherheit weiter erhöht wird. Prinzipiell können bei der Vorrichtung die verschiedenen Kanäle mit verschiedenen Spannungen bzw. maximalen Spannungsamplituden ihres jeweiligen Eingangssignals gleichzeitig betrieben und die Eingangssignale dabei zuverlässig ausgewertet werden. Eine wie vorstehend beschriebene nicht-galvanische Signalübertragung bzw. galvanische Trennung erhöht die Sicherheit und Zuverlässigkeit der Vorrichtung insbesondere bei einem solchen Betrieb mit verschiedenen Spannungen.

Die nicht-galvanische Signalübertragung kann derart erfolgen, dass die Form und insbesondere der Zeitverlauf des gepulsten Signals im Wesentlichen erhalten bleiben. Das nicht-galvanisch übertragene Signal kann ein binärwertiges und/oder unipolares Signal mit vorzugsweise zumindest näherungsweise senkrechten steigenden und fallenden Flanken sein, insbesondere ein pulsweitenmoduliertes Signal. Die Spannungsamplitude des übertragenen Signals kann dabei so angepasst sein, dass sie einem zulässigen Spannungswert entspricht, der an dem Eingang des gemeinsamen Mikroprozessors erwartet wird, an dem das Signal empfangen wird.

Der gemeinsame Mikroprozessor kann dazu eingerichtet sein, die vorzugsweise nicht-galvanisch übertragenen, aus den Empfangssignalen der Kanäle abgeleiteten Signale an verschiedenen Eingängen des gemeinsamen Mikroprozessors zu empfangen und parallel zu verarbeiten. Dadurch wird eine simultane Auswertung mehrerer Kanäle mit geringen Ressourcen und geringem Aufwand ermöglicht.

Gemäß einer Ausführungsform ist der gemeinsame Mikroprozessor dazu eingerichtet, das gepulste Signal oder ein von dem gepulsten Signal abgeleitetes Signal zumindest eines Kanals und insbesondere jedes Kanals so auszuwerten, dass eine steigende Flanke und/oder eine fallende Flanke eines Pulses des ausgewerteten Signals jeweils zu einem Interrupt in dem Mikroprozessor führt. Dadurch kann gewährleistet werden, dass das Ereignis des Auftretens der steigenden bzw. fallenden Flanke innerhalb einer vorgegebenen Zeitdauer erkannt wird und zu einer geeigneten Aktion des Mikroprozessors führt. Der Interrupt kann z.B. dazu führen, dass ein zur Bestimmung der Pulsbreite verwendeter Zähler gestartet oder angehalten und ggf. zurückgesetzt sowie ggf. ausgelesen wird. So kann eine genaue und in Echtzeit erfolgende parallele Auswertung der Pulsbreiten aller empfangenen Signale durch den Mikroprozessor sichergestellt werden.

Der Mikroprozessor kann zumindest für einen und insbesondere für jeden Kanal einen Interrupt-Signaleingang zum Empfangen des gepulsten Signals des Kanals oder des von dem gepulsten Signal abgeleiteten Signals des Kanals aufweisen, der so ausgebildet ist, dass eine steigende oder fallende Signalflanke an dem Interrupt-Eingang zu einem Interrupt führt.

Gemäß einer vorteilhaften Ausführungsform ist der gemeinsame Mikroprozessor dazu eingerichtet, festzustellen, ob die Spannungsamplitude des Eingangssignals eines Kanals einen vorgegebenen Schwellwert übersteigt. Da die Spannungsamplitude des Eingangssignals wie vorstehend beschrieben durch die Pulsbreite des an dem gemeinsamen Mikroprozessor empfangenen Signals repräsentiert wird, vergleicht der gemeinsame Mikroprozessor dazu vorzugsweise die Pulsbreite des empfangenen Signals bzw. den die Pulsbreite repräsentierenden digitalen Wert mit einem entsprechenden Schwellwert von z.B. 20 µs. Diese Konfiguration eignet sich zur Auswertung binärer Eingangssignale, bei denen eine Spannungsamplitude oberhalb des Schwellwerts einen logischen Zustand repräsentiert und eine Spannungsamplitude unterhalb des Schwellwerts den anderen logischen Zustand repräsentiert. Das Eingangssignal kann beispielsweise den Schaltzustand eines Schaltgeräts eines Schaltfelds repräsentieren und anzeigen, ob das Schaltgerät geschlossen oder geöffnet ist.

Vorzugsweise ist der Schwellwert, mit dem der gemeinsame Mikroprozessor die Spannungsamplitude vergleicht, einstellbar. Dadurch wird es ermöglicht, die Auswertung flexibel an eine dem jeweiligen Eingangssignal zugrundeliegende maximale Spannungsamplitude bzw. den Betrag einer dem Eingangssignal zugrundeliegenden Hilfsspannung des Schaltfelds anzupassen. Der Schwellwert kann digital einstellbar bzw. programmierbar sein, insbesondere durch eine mit dem Mikroprozessor, z.B. über ein Bussystem, kommunizierende übergeordnete Steuerung. Der Schwellwert ist vorzugsweise so gewählt bzw. wird so eingestellt, dass zuverlässig erkannt wird, ob das Eingangssignal eine hohe Spannungsamplitude aufweist, welche eine logische "1" repräsentieren kann und durch den Betrag der Hilfsspannung gegeben sein kann, oder eine niedrige Spannungsamplitude, welche eine logische "0" repräsentieren kann.

Der gemeinsame Mikroprozessor kann dazu eingerichtet sein, zum Beispiel über ein Bussystem, mit einer übergeordneten Steuerung zu kommunizieren. Vorzugsweise ist der gemeinsame Mikroprozessor dazu eingerichtet, die durch die Auswertung der Eingangssignale gewonnenen Informationen an die übergeordnete Steuerung zu melden und/oder Steuersignale von der übergeordneten Steuerung zu empfangen. Die übergeordnete Steuerung kann von der Vorrichtung getrennt ausgebildet sein und/oder zur Überwachung mehrerer Schaltfelder eingerichtet sein und kann z.B. eines oder mehrere Computersysteme umfassen.

Gemäß einer vorteilhaften Ausführungsform ist wenigstens ein Ausgang vorgesehen, der von dem gemeinsamen Mikroprozessor steuerbar ist. Der Mikroprozessor kann also sowohl eine Überwachungsfunktion in Form der Überwachung und Auswertung der Eingangssignale erfüllen, als gleichzeitig auch eine Steuerfunktion, insbesondere zur Steuerung eines Schaltfelds. Der Ausgang kann ein von dem Mikroprozessor ansteuerbares Steuerelement wie zum Beispiel ein Relais umfassen. Das steuerbare Element weist vorzugsweise eine Steuerstromstrecke, insbesondere die Steuerstromstrecke eines Relais, auf, die mit einem Signalausgang des gemeinsamen Mikroprozessors steuerwirksam gekoppelt ist, wobei die Kopplung zweckmäßigerweise über zumindest einen Transistor oder insbesondere ein Darlington-Transistorpaar erfolgen kann.

Vorzugsweise ist der wenigstens eine Ausgang von dem gemeinsamen Mikroprozessor in Abhängigkeit von der Spannungsamplitude zumindest eines Eingangssignals steuerbar. Der Mikroprozessor kann die durch die Spannungsamplitude repräsentierten Informationen dann unmittelbar nutzen, um abhängig davon eine Steuerentscheidung zu treffen und einen Steuervorgang durchzuführen. Alternativ oder zusätzlich kann der wenigstens eine Ausgang von dem Mikroprozessor auch in Abhängigkeit von einem oder mehreren von einer übergeordneten Steuerung, insbesondere über ein Bussystem, empfangenen Steuersignalen steuerbar sein. Die Steuerentscheidung kann dann von der übergeordneten Steuerung getroffen werden, z.B. in Abhängigkeit von Informationen, die von dem gemeinsamen Mikroprozessor gemeldet wurden.

Bei dem Einsatz der Vorrichtung in einer Schaltanlage ist der Ausgang der Vorrichtung vorzugsweise mit einem Schaltgerät gekoppelt, so dass das Schaltgerät über den Ausgang von dem gemeinsamen Mikroprozessor ansteuerbar ist, insbesondere um durch die Steuersignale des gemeinsamen Mikroprozessors einen Schaltvorgang des Schaltgeräts auszulösen, d.h. das Schaltgerät z.B. zu öffnen oder zu schließen. Dazu kann das Relais mit einem den Schaltvorgang bewirkenden Antrieb und insbesondere Motor gekoppelt sein und diesen ansteuern. Es können auch mehrere von dem gemeinsamen Mikroprozessor ansteuerbare Ausgänge vorhanden sein, die gemäß der vorstehenden Beschreibung ausgebildet sind und vorzugsweise jeweils einem Schaltgerät eines Schaltfelds zugeordnet sind.

Die Vorrichtung kann Teil eines Feldgeräts für ein Schaltfeld sein. Die Vorrichtung kann zumindest teilweise durch diskrete elektronische Bauelemente realisiert sein. Beispielsweise können die vorstehend beschriebenen Elemente Mikroprozessor, Brückengleichrichter, elektrischer Widerstand, Kondensator, Transistor, Operationsverstärker, Varistor, PTC-Widerstand, integrierter Schaltkreis, Zener-Diode und Optokoppler jeweils durch ein diskretes elektronisches Bauelement realisiert sein. Die Bauelemente können dabei auf einer gemeinsamen Leiterplatte angeordnet sein. Die Vorrichtung lässt sich mit herkömmlichen und dementsprechend kostengünstig verfügbaren Mitteln bereitstellen und auf kleinem Bauraum realisieren. Ferner erlaubt die Anordnung auf einer Leiterplatte die einfache Anbindung an die übrigen Komponenten einer Schaltanlage, insbesondere die entsprechenden Signalgeber der primärtechnischen Mittel der Schaltfelder und/oder ein übergeordnetes Steuerungssystem.

Die Leiterplatte kann insbesondere zusammen mit weiteren Leiterplatten in einem Baugruppenträger, einem so genannten "Rack", angeordnet werden, wodurch eine platzsparende und elektrisch sichere Aufbewahrung gewährleistet wird.

Weiterer Gegenstand der Erfindung ist eine Schaltanlage für die Mittel- oder Hochspannungstechnik mit zumindest einer erfindungsgemäßen Vorrichtung gemäß der vorliegenden Beschreibung. Die vorstehend in Bezug auf die Vorrichtung sowie deren Einsatz in einer Schaltanlage beschriebenen Vorteile und vorteilhaften Ausführungsformen stellen bei entsprechender Anwendung Vorteile und vorteilhafte Ausführungsformen der Schaltanlage dar. Die Vorrichtung kann einem Schaltfeld der Schaltanlage zugeordnet sein und z.B. Teil eines dem Schaltfeld zugeordneten Feldgeräts zur Überwachung und ggf. Ansteuerung des Schaltfelds sein.

Vorzugsweise ist zumindest ein Eingang der Vorrichtung mit einem Signalgeber verbunden, der einem primärtechnischen Mittel eines Schaltfelds der Schaltanlage zugeordnet ist, um ein von dem Signalgeber erzeugtes Meldesignal, welches insbesondere auf einer Versorgungsspannung bzw. Hilfsspannung des Schaltfelds basiert, zu empfangen. Die Spannungsamplitude des Meldesignals kann dabei einen logischen Zustand, insbesondere den Schaltzustand eines Schaltgeräts des Schaltfelds, repräsentieren. Beispielsweise kann das Meldesignal binär sein, wobei eine hohe Spannungsamplitude, welche insbesondere der Amplitude einer Hilfsspannung des Schaltfelds entsprechen kann, einen Zustand repräsentiert und eine niedrige Spannungsamplitude von zum Beispiel 0 Volt den anderen Zustand repräsentiert.

Ein Ausgang der Vorrichtung kann dazu verwendet werden, ein Schaltgerät eines Schaltfelds anzusteuern und abhängig von der in dem gemeinsamen Mikroprozessor vorgenommenen logischen Auswertung einen Schaltvorgang des Schaltgeräts auszulösen, d.h. das Schaltgerät insbesondere zu öffnen oder zu schließen.

Der Mikroprozessor kann, zum Beispiel über ein Bussystem, mit einer übergeordneten Steuerung kommunizieren und die durch die Auswertung der Eingangssignale gewonnenen Informationen an die übergeordnete Steuerung melden und/oder Steuersignale von der übergeordneten Steuerung empfangen. Die übergeordnete Steuerung kann dabei der Steuerung und Überwachung mehrerer Schaltfelder dienen.

Unter Mittelspannung wird hierin eine Spannung von wenigstens 1 kV und höchstens 52 kV verstanden und unter Hochspannung eine Spannung von wenigstens 52 kV, wobei der Begriff der Hochspannung vorzugsweise auch eine Höchstspannung, d.h. eine Spannung von mehr als 110 kV und z.B. bis zu 380 kV umfasst.

Nachfolgend wird die Erfindung beispielhaft anhand vorteilhafter Ausführungsformen unter Bezugnahme auf die beigefügten Figuren beschrieben. Es zeigen:
- Fig. 1: eine Vorrichtung gemäß einer Ausführungsform der Erfindung in schematischer Darstellung,
- Fig. 2 bis 4: beispielhafte Signalverläufe in Bezug auf die in Fig. 1 gezeigte Vorrichtung,
- Fig. 5: einen Teil einer Vorrichtung gemäß einer weiteren Ausführungsform der Erfindung in schematischer Darstellung, und
- Fig. 6 bis 9: Ausgänge einer Vorrichtung gemäß einer Ausführungsform der Erfindung.

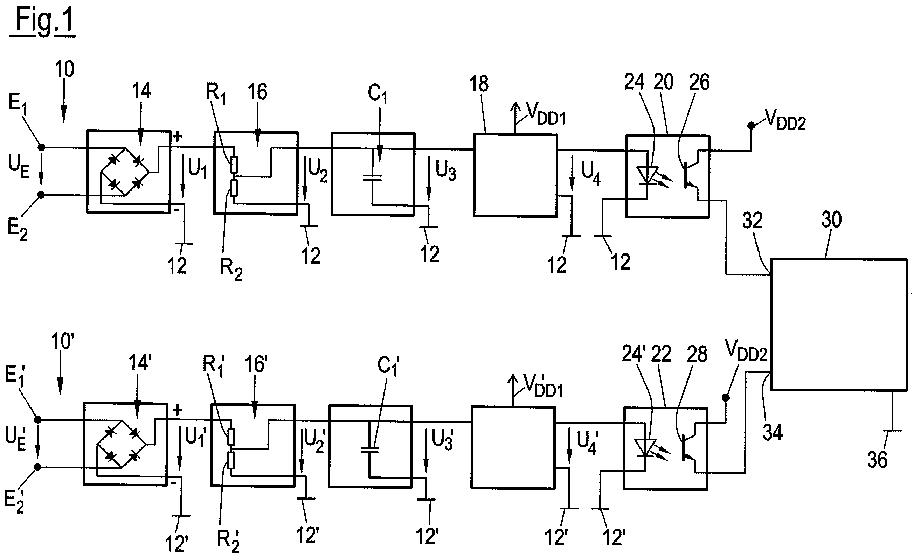

Die in Fig. 1 gezeigte Vorrichtung umfasst zwei identisch ausgestaltete, in Fig. 1 übereinander dargestellte Kanäle für jeweils ein Eingangssignal, wobei die Komponenten des oberen Kanals in Fig. 1 mit ungestrichenen Bezugszeichen (z.B. 10) und die Komponenten des unteren Kanals mit gestrichenen Bezugszeichen (z.B. 10') bezeichnet sind. Nachfolgend ist der obere Kanal stellvertretend für die beiden identischen Kanäle beschrieben.

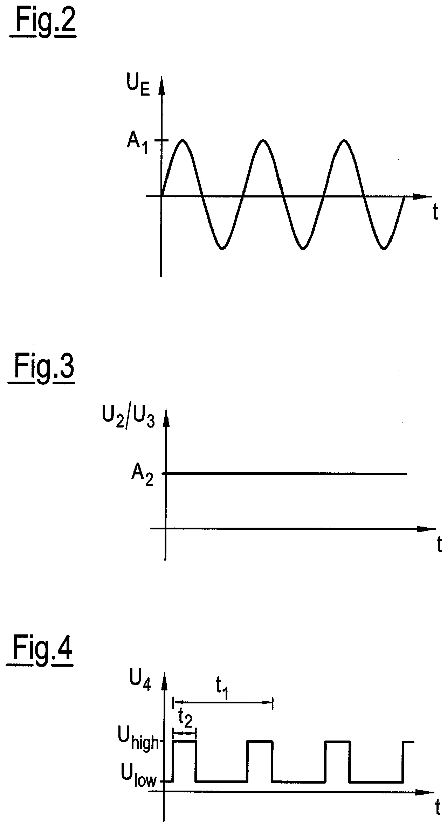

Der Kanal umfasst einen Eingang 10 mit zwei Anschlüssen E₁, E₂, zwischen denen die Spannung U_{E} des Eingangssignals anliegt. Fig. 2 zeigt einen beispielhaften Zeitverlauf des durch die Spannung U_{E} gebildeten Eingangssignals, welches im vorliegenden Fall als sinusförmiges Wechselspannungssignal mit Netzfrequenz ausgebildet ist, wobei die Information in der durch den Scheitel der Sinusschwingung definierten Spannungsamplitude enthalten ist, welche im Falle eines binären Eingangssignals zum Beispiel zwischen dem in Fig. 2 gezeigten Wert A₁ und einem geringeren Wert, insbesondere näherungsweise 0 Volt, wechseln kann. Prinzipiell wird unter der Spannungsamplitude die maximale Auslenkung des Spannungssignals innerhalb eines betrachteten Zeitraums verstanden, d.h. z.B. der Scheitelwert eines Wechselspannungssignals bzw. der im Wesentlichen konstante Spannungswert eines Gleichstromsignals.

Das Eingangssignal wird einem Brückengleichrichter 14 zugeführt, der aus dem Eingangssignal ein gleichgerichtetes Signal erzeugt, das durch die zwischen dem positiven bzw. "+"-Anschluss und dem negativen bzw. "-"-Anschluss des Brückengleichrichters 14 anliegende Spannung U₁ gebildet ist. Dabei werden die negativen Signalanteile, d.h. die negativen Halbwellen des in Fig. 2 gezeigten Sinussignals, vorzeichenumgekehrt, d.h. an der Zeitachse t in den positiven Spannungsbereich gespiegelt. Das Bezugszeichen 12 definiert einen gemeinsamen Masseanschluss des Kanals und ist mit dem "-"-Anschluss des Brückengleichrichters verbunden. Mit dem gleichen Bezugszeichen versehene Anschlüsse sind im Rahmen dieser Beschreibung stets als auf demselben Potential liegend anzusehen.

Die gleichgerichtete Spannung U₁ liegt an einem Spannungsteiler 16 an, welcher einen ersten Widerstand R₁ und einen dazu in Serie geschalteten zweiten Widerstand R₂ aufweist. Das Verhältnis des Werts des zweiten Widerstands R₂ zu dem Wert des ersten Widerstands R₁ definiert ein Teilungsverhältnis des Spannungsteilers und die über den zweiten Widerstand R₂ abfallende Spannung U₂ bildet ein skaliertes Signal, welches eine gegenüber dem Eingangssignal U_{E} verringerte Spannungsamplitude aufweist.

Zu dem zweiten Widerstand R₂ ist ein Kondensator C₁ parallel geschaltet, welcher eine Glättung des skalierten Signals bewirkt. Die über den zweiten Widerstand R₂ abfallende Spannung U_{E} ist mit der über den Kondensator C₁ abfallenden Spannung U₃ identisch und definiert ein skaliertes und geglättetes Signal. Unter der Annahme einer perfekten Glättung bildet die Spannung U₂/U₃ ein wie in Fig. 3 gezeigtes Gleichspannungssignal mit einer gegenüber der Amplitude A₁ des Eingangssignals verringerten Amplitude A₂. Die Amplitude A₂ ist dabei vorzugsweise zumindest näherungsweise proportional zu der Amplitude A₁, wobei der Proportionalitätsfaktor variieren kann, je nachdem ob das Eingangssignal ein Wechselspannungssignal oder Gleichspannungssignal ist.

Die Spannung U₂/U₃ liegt an einem analogen Signaleingang des Mikroprozessors 18 an, der dazu eingerichtet ist, aus dem durch die Spannung U₂/U₃ definierten Signal ein gepulstes Signal zu erzeugen, welches durch die an dem Ausgang des Mikroprozessors 18 bereitgestellte Spannung U₄ gebildet ist. Ein beispielhaftes gepulstes Signal ist in Fig. 4 gezeigt. Der Mikroprozessor 18 ist vorliegend dazu eingerichtet, ein pulsweitenmoduliertes Signal mit einer Tastperiode t₁ und einer Pulsbreite t₂ zu erzeugen, wobei die Pulsbreite t₂ zumindest näherungsweise proportional zu der Amplitude A₂ des durch die Spannung U₂/U₃ definierten Signals ist. Die Tastperiode t₁ kann z.B. eine Länge von weniger als 1 ms und insbesondere weniger als 500 µs aufweisen. Das pulsweitenmodulierte Signal ist binärwertig und wechselt zwischen einem niedrigen Spannungswert Uiow und einem hohen Spannungswert U_{high}.

Der Optokoppler 20 dient zur nicht-galvanischen Übertragung des gepulsten Signals zu dem gemeinsamen Mikroprozessor 30. Die Spannung U₄ liegt dazu an einem Empfänger 24 des Optokopplers an, welcher durch eine Leuchtdiode gebildet ist. Der Empfänger 26 des Optokopplers 20 ist durch eine fotoempfindlichen Transistorstrecke gebildet, die bei leuchtendem Sender 24 eine Versorgungsspannung zu dem Emitter durchschaltet, die zwischen dem mit dem Kollektoreingang der Transistorstrecke 26 verbundenen Anschluss Vdd₂ und dem Masseanschluss 36 bereitgestellt wird. Der Emitter ist mit dem Signaleingang 32 des Mikroprozessors 30 verbunden, an dem folglich ein auf der Versorgungsspannung des Anschlusses Vdd₂ basierendes Spannungssignal empfangen wird, welches in Bezug auf seinen Zeitverlauf mit dem durch die Spannung U₄ definierten gepulsten Signal im Wesentlichen identisch ist.

Dem unteren Kanal in Fig. 1 ist ein Optokoppler 22 zugeordnet, dessen Sender 24' mit dem Mikroprozessor 18' des unteren Kanals verbunden ist und dessen Empfänger 28 mit dem Anschluss Vdd₂ und einem weiteren Signaleingang 34 des Mikroprozessors 30 verbunden ist.

Der Optokoppler 20 trennt den oberen Kanal galvanisch von dem den Mikroprozessor 30 umfassenden Schaltkreis. Der obere Kanal ist dabei vorzugsweise, zumindest bei unbeschalteter Vorrichtung, vollständig galvanisch von dem den Mikroprozessor 30 umfassenden Schaltkreis und von dem unteren Kanal getrennt. Der obere Kanal kann dazu eine in Fig. 1 nicht dargestellte Stromversorgungsschaltung aufweisen, die dazu ausgebildet ist, aus der Eingangsspannung U_{E} eine im Wesentlichen konstante Versorgungsgleichspannung abzuleiten, die z.B. dem Mikroprozessor 18 über einen Versorgungsspannungsanschluss Vdd₁ zur Verfügung gestellt wird. Diese Spannung dient zur Stromversorgung des Mikroprozessors 18. Der den Mikroprozessor 30 umfassende Schaltkreis umfasst demgegenüber eine separate Spannungsversorgung mit einer zwischen den Anschlüssen Vdd₂ und dem Masseanschluss 36 dieses Schaltkreises bereitgestellten Versorgungsspannung.

Der Mikroprozessor 30 empfängt an den Signaleingängen 32, 34 die nicht-galvanisch übertragenen Signale von den Optokopplern 20, 22, welche in Bezug auf ihre Form den von den Mikroprozessoren 18, 18' erzeugten gepulsten Signalen entsprechen. Die Eingänge 32, 34 sind als Interrupt-Signaleingänge ausgebildet und der Mikroprozessor 30 ist so eingerichtet, dass eine steigende oder fallende Flanke des empfangenen Signals einen Interrupt in dem Mikroprozessor 30 bewirkt. Die Interrupts dienen dazu, die Pulsbreiten der empfangenen Signale, zum Beispiel durch entsprechendes Zurücksetzen bzw. Auslesen von Zählern, zu messen und dadurch die Signalamplitude A₁ des jeweiligen Eingangssignals als digitalen Wert zu bestimmen.

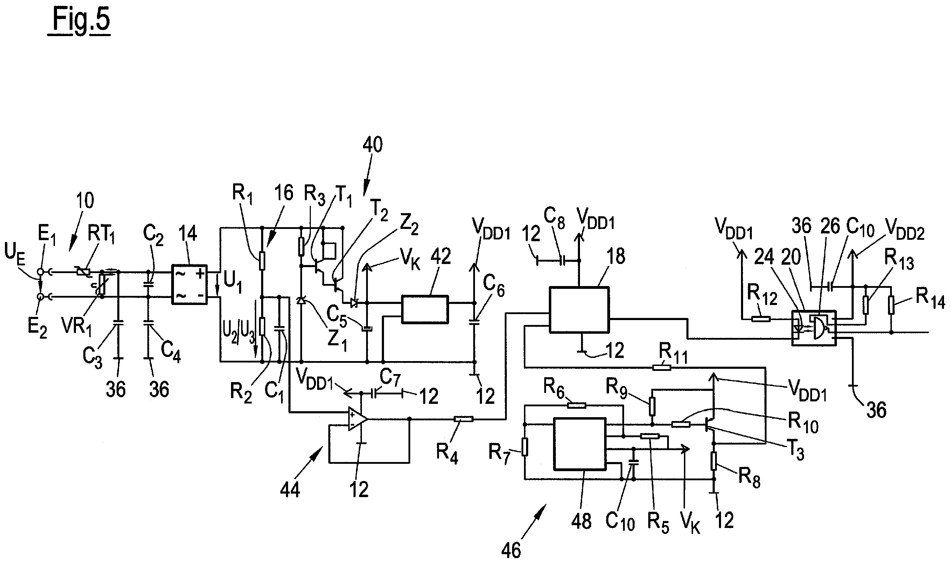

Fig. 5 zeigt einen Kanal einer Vorrichtung gemäß einer weiteren Ausführungsform der Erfindung und Mittel zur nicht-galvanischen Anbindung des Kanals an einen gemeinsamen Mikroprozessor. Der Kanal entspricht im Wesentlichen dem vorstehend in Bezug auf Fig. 1 beschriebenen Kanal, wobei im Nachstehenden vornehmlich die zusätzlichen in Fig. 5 gezeigten Merkmale beschrieben sind. Einander entsprechende Elemente sind in Fig. 1 und 5 mit gleichen Bezugszeichen versehen.

Der Kanal umfasst eine Schutzbeschaltung, welche den Brückengleichrichter 14 und die nachfolgenden Komponenten schützt. Diese umfasst einen zwischen dem Anschluss E₁ und dem zugehörigen Eingang des Brückengleichrichters 14 in Serie geschalteten PTC-Widerstand RT₁, welcher den Gleichrichter 14 und die nachfolgenden Komponenten vor Überströmen schützt. Ferner ist zwischen den Anschlüssen E₁ und E₂ ein Varistor VR₁ angeschlossen, welcher den Gleichrichter 14 vor Überspannungen schützt. Außerdem sind im Bereich des Eingangs 10 Kondensatoren C₂, C₃ und C₄ angeordnet, die die Anschlüsse E₁ und E₂ miteinander bzw. mit einem dem Schaltkreis des in Fig. 5 nicht dargestellten gemeinsamen Mikroprozessors zugeordneten Masseanschluss 36 kapazitiv koppeln.

Der in Fig. 5 gezeigte Kanal umfasst eine Stromversorgungsschaltung 40, die zu dem Spannungsteiler 16 parallel geschaltet ist und an der die zwischen dem positiven und dem negativen Anschluss des Brückengleichrichters vorhandene Spannung U₁ anliegt. Die Stromversorgungsschaltung 40 umfasst eine Zener-Diode Z₁, die in Bezug auf den positiven Anschluss und den negativen Anschluss des Brückengleichrichters 14 in Sperrpolung geschaltet ist, wobei die Durchbruch- bzw. Zener-Spannung der Zener-Diode Z₁ als Referenzspannung für die Stromversorgungsschaltung 40 dient und vorzugsweise geringer gewählt ist als die erwartete Spannungsamplitude des Eingangssignals bei hohem Signalpegel.

Die Kathode der Zener-Diode Z₁ ist mit der Basis eines Bipolartransistors T₁ und über einen Widerstand R₃ mit dem positiven Anschluss des Gleichrichters 14 verbunden, mit dem auch der Kollektor des Transistors T₁ verbunden ist. An dem Emitter des Transistors T₁ liegt eine Spannung gegenüber dem Masseanschluss 12 an, welche der Spannung über die Zener-Diode Z₁ entspricht und etwas geringer als diese ist. Der Transistor T₁ und der Widerstand R₃ stellen sicher, dass die Spannung U₁ durch die Schaltung 40 nur gering belastet wird. Der Emitter des Transistors T₁ ist mit der Basis eines weiteren Bipolartransistors T₂ verbunden, dessen Kollektor mit dem positiven Anschluss des Gleichrichters 14 verbunden ist. Der Transistor T₂ bewirkt eine noch geringere Belastung der Spannung U₁ durch die Schaltung 40 und stellt an seinem Emitter eine Spannung bereit, welche etwas geringer ist als die Emitterspannung des Transistors T₁.

An den Emitter des Transistors T₂ ist eine in Flussrichtung gepolte Zener-Diode Z₂ angeschlossen, deren Kathode über einen Elektrolytkondensator C₅ mit dem Masseanschluss 12 verbunden ist. Der Transistor C₅ bewirkt eine Glättung der Spannung derart, dass über den Kondensator C₅ eine im Wesentlichen konstante Spannung abfällt, welche als Kontrollspannung dient und an dem Anschluss V_{K} bereitgestellt wird. Die vorstehend beschriebenen Komponenten sind beispielsweise so bemessen, dass die Kontrollspannung in etwa 10 Volt beträgt, solange das durch die Spannung U₁ gebildete Spannungssignal eine Spannungsamplitude von 12 V oder mehr aufweist. Die Kontrollspannung wird einem durch einen integrierten Schaltkreis gebildeten Spannungsstabilisator 42 zugeführt, welcher daraus eine Gleichspannung generiert, deren Wert niedriger ist als die Kontrollspannung und im vorliegenden Ausführungsbeispiel etwa 5 V betragen kann, solange die Eingangsspannung U_{E} eine ausreichende Spannungsamplitude aufweist. Am Ausgang des Stabilisators 42 sind ein Kondensator C₆ zur Glättung der erzeugten Spannung und ein Anschluss Vdd₁ zur Bereitstellung der erzeugten Gleichspannung an die damit zu versorgenden Komponenten des Kanals vorgesehen. Neben dem Kondensator C₆ sind auch die Kondensatoren C₇ und C₈ zwischen dem Anschluss Vdd₁ und dem Masseanschluss 12 des Kanals angeschlossen.

Die skalierte und geglättete Spannung U₂/U₃ liegt an dem Eingang eines Spannungsfolgers 44 an, welcher zur Impedanzwandlung dient und eine Ausgangsspannung an seinem Ausgang erzeugt, die der an seinem Eingang anliegenden Spannung U₂/U₃ entspricht. Der Ausgang des Spannungsfolgers 44 ist über einen Widerstand R₄ mit einem Signaleingang des Mikroprozessors 18 verbunden, der das gepulste Signal erzeugt.

Ferner ist eine Schwellwertschaltung 46 vorgesehen, welche dazu eingerichtet ist, die an dem Anschluss V_{K} vorliegende Kontrollspannung mit einem vorgegebenen Schwellwert zu vergleichen. Die Schaltung 46 umfasst einen integrierten Schaltkreis 48, welcher zur Durchführung des Schwellwertvergleichs dient. Wie in Fig. 5 gezeigt, ist ein Eingang des integrierten Schaltkreises 48 mit dem Anschluss V_{K} verbunden. Der Anschluss V_{K} ist zusätzlich über elektrische Widerstände R₅, R₆ und R₇ mit weiteren Eingängen des integrierten Schaltkreises 48 verbunden. Die Widerstände R₅, R₆, R₇ dienen dazu, den Schwellwert einzustellen, mit dem die Kontrollspannung effektiv verglichen wird, wobei der Schwellwert im vorliegenden Ausführungsbeispiel auf etwa 10 Volt eingestellt sein kann. Ein Kondensator C₁₀ verbindet V_{K} mit dem Masseanschluss 12.

Der Ausgang des integrierten Schaltkreises 48 ist über elektrische Widerstände R₈, R₉ und R₁₀ mit einem Bipolartransistor T₃ verbunden, welcher an seinem Kollektor ein von dem Ergebnis des Schwellwertvergleichs abhängiges Ausgangssignal erzeugt. Dieses Signal wird über einen Widerstand R₁₁ zu einem Signaleingang des Mikroprozessors 18 übertragen und meldet dem Mikroprozessor, wenn die Kontrollspannung den Schwellwert unterschreitet, was bedeutet, dass an dem Versorgungsanschluss Vdd₁ ebenfalls eine zu geringe Versorgungsspannung droht. Vorzugsweise ist der Mikroprozessor 18 dazu eingerichtet, das Erzeugen des gepulsten Ausgangssignals zu unterbinden, wenn eine solche Schwellwertunterschreitung gemeldet wird, so dass die Ausgangsspannung U₄ in diesem Fall einen dauerhaft konstanten Wert von z.B. 0 V annimmt.

Das durch die Spannung U₄ repräsentierte gepulste Signal wird durch einen Optokoppler 20 nicht-galvanisch zu dem in Fig. 5 nicht dargestellten Mikroprozessor übertragen. Dazu ist die Kathode der Leuchtdiode 24 des Optokopplers mit dem Signalausgang des Mikroprozessors 18 verbunden und die Anode der Leuchtdiode 24 ist über einen Widerstand R₁₂ mit dem Anschluss Vdd₁ verbunden. Der Empfänger 26 des Optokopplers 20 ist durch einen fotoempfindlichen Inverter gebildet, dessen Eingang über einen Widerstand R₁₃ mit dem Versorgungsspannungsanschluss Vdd₂ verbunden ist und dessen invertierender Ausgang mit einem Signaleingang des gemeinsamen Mikroprozessors und außerdem über einen Widerstand R₁₄ mit dem Anschluss Vdd₂ verbunden ist. Ein Kondensator C₁₀ verbindet den Anschluss Vdd₂ mit dem Masseanschluss 36.

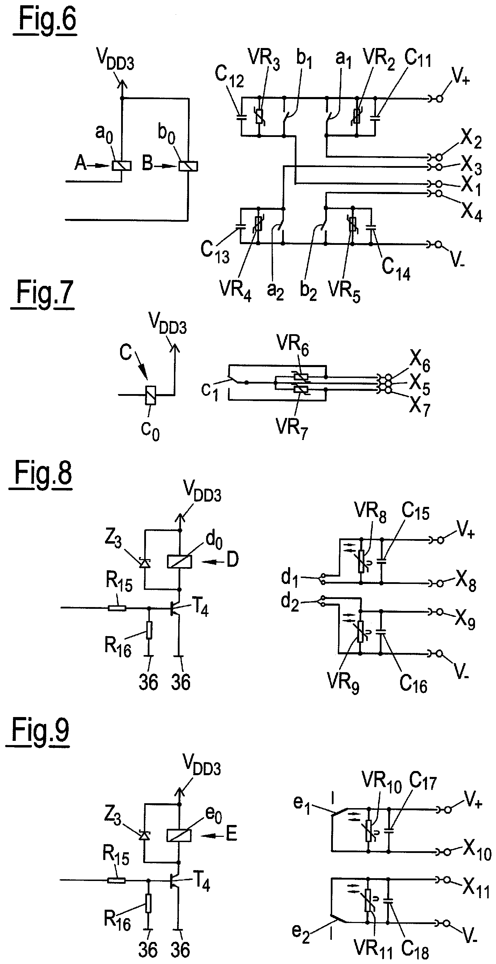

Fig. 6 bis 9 zeigen Ausgänge, die von dem gemeinsamen Mikroprozessor der Vorrichtung ansteuerbar sind.

Der in Fig. 6 gezeigte Ausgang umfasst zwei Relais A, B, deren Erregungsstromstrecken a₀, b₀ zwischen einem eine Gleichspannung von z.B. 24 V bereitstellenden Versorgungsspannungsanschluss Vdd₃ und einem Steuerausgang des nicht dargestellten gemeinsamen Mikroprozessors angeschlossen sind, so dass die Relais A, B abhängig von Steuersignalen des Mikroprozessors erregbar sind. Die Relais A, B umfassen Schließerkontakte a₁, b₁, a₂, b₂, die jeweils einen Stromversorgungsanschluss V₊, V₋ mit einem Ausgangsanschluss X₁, X₂, X₃ und X₄ verbinden. Die Anschlüsse X₁, X₂, X₃ und X₄ können jeweils zu einem Motor führen, der z.B. einen Antrieb zur Umschaltung eines Schaltgeräts eines Schaltfelds darstellt, so dass der Motor über die Relaiskontakte a₁, b₁, a₂, b₂ mit der Versorgungsspannung an dem Anschluss V₊ bzw. V₋ versorgbar ist. Parallel zu den Relaiskontakten a₁, b₁, a₂, b₂ sind jeweils ein Varistor VR₂, VR₃, VR₄, VR₅ als Überspannungsschutz und ein Kondensator C₁₁, C₁₂, C₁₃, C₁₄ angeschlossen.

Fig. 7 zeigt einen Ausgang mit einem von dem Mikroprozessor in der vorstehend in Bezug auf Fig. 6 beschriebenen Weise ansteuerbaren Relais C. Das Relais C umfasst einen Wechselkontakt c₁, mit dem ein gemeinsamer Anschluss X₆ selektiv mit einem von zwei weiteren Anschlüssen X₇ bzw. X₈ verbindbar ist. Varistoren VR₆, VR₇ schützen den Ausgang vor Überspannungen zwischen dem gemeinsamen Anschluss X₆ und den Anschlüssen X₇, X₈.

Fig. 8 zeigt einen Ausgang mit einem von dem gemeinsamen Mikroprozessor ansteuerbaren Relais D. Der Ausgang des Mikroprozessors ist über einen Widerstand R₁₅ mit der Basis eines Bipolartransistors T₄ verbunden, dessen Emitter mit dem Masseanschluss 36 verbunden ist. Zwischen dem Kollektor des Transistors T₄ und dem Versorgungsspannungsanschluss Vdd₃ ist die Erregungsstromstrecke d₀ des Relais D angeordnet und parallel dazu ist eine in Sperrrichtung gepolte Zener-Diode Z₃ angeschlossen. Die Schließerkontakte d₁ und d₂ des Relais D sind in der vorstehend in Bezug auf Fig. 6 beschriebenen Weise zwischen einem Versorgungsspannungsanschluss V₊ bzw. V₋ und einem beispielsweise zu einem Motor für ein Schaltgerät oder zu einer Spule führenden Ausgangsanschluss X₈, X₉ angeschlossen. Parallel zu den Schließerkontakten d₁, d₂ ist jeweils ein Varistor VR₈, VR₉ als Überspannungsschutz und ein Kondensator C₁₅, C₁₆ angeschlossen.

Fig. 9 zeigt einen Ausgang, welcher im Wesentlichen dem in Fig. 8 gezeigten Ausgang entspricht, wobei allerdings ein Wechselkontaktrelais E mit zwei über die Erregungsstromstrecke eo betätigbaren Wechselkontakten e₁, e₂ eingesetzt wird, welche den Stromkreis zwischen dem Versorgungsspannungsanschluss V₊, V₋ und dem zugehörigen Anschluss X₁₀, X₁₁ im nicht erregten Zustand des Relais E schließen, so dass ein invertierender Ausgang realisiert wird. Ansonsten entspricht der in Fig. 9 gezeigte Ausgang dem in Fig. 8 gezeigten Ausgang und umfasst zwischen den Anschlüssen V₊ bzw. V₋ und den Anschlüssen X₁₀ bzw. X₁₁ angeschlossene Varistoren VR₁₀, VR₁₁ und Kondensatoren C₁₇, C₁₈.

### Bezugszeichenliste

- 10, 10': Eingang
- 12, 12': Masseanschluss
- 14, 14': Brückengleichrichter
- 16, 16': Spannungsteiler
- 18, 18': Mikroprozessor
- 20, 22: Optokoppler
- 24, 24': Sender
- 26: Empfänger
- 28: Empfänger
- 30: Mikroprozessor
- 32: Interrupt-Signaleingang
- 34: Interrupt-Signaleingang
- 36: Masseanschluss
- 40: Stromversorgungsschaltung
- 42: Spannungsstabilisator
- 44: Spannungsfolger
- 46: Schwellwertschaltung
- 48: integrierter Schaltkreis

- A₁, A₂: Amplitude
- A, B, C, D, E: Relais
- a₀, b₀, c₀, d₀, e₀: Erregungsstromstrecke
- a₁, a₂, b₁, b₂, d₁, d₂: Schließerkontakt
- C₁ - C₁₈, C₁': Kondensator
- c₁, e₁, e₂: Wechselkontakt
- E₁, E₂, E₁', E₂': Eingangsanschluss
- R₁- R₁₆, R₁', R₂',: elektrischer Widerstand
- RT₁: PTC-Widerstand
- t: Zeit
- t₁: Periodendauer
- t₂: Pulsbreite
- T₁ - T₄: Bipolartransistor
- U_{E}, U_{E}',: Eingangsspannung
- U₁ - U₄, U₁' - U₄': elektrische Spannung
- U_{low}: niedrige Spannungsamplitude
- U_{high}: hohe Spannungsamplitude
- Vdd₁, Vdd₂, Vdd₃: Versorgungsspannungsanschluss
- V₊, V₋: Versorgungsspannungsanschluss
- V_{K}: Kontrollspannungsanschluss
- VR₁ - VR₁₁: Varistor
- X₁ - X₁₁: Ausgangsanschluss
- Z₁, Z₂, Z₃: Zener-Diode

## Patentansprüche

1. Vorrichtung zur Auswertung von Eingangssignalen in einer Schaltanlage für die Mittel- oder Hochspannungstechnik, mit mehreren Kanälen, wobei jeder Kanal folgende Komponente umfasst:
- einen Eingang (E₁, E₂, E₁', E₂') zum Empfangen eines elektrischen Eingangssignals, und
- eine Signalverarbeitungseinrichtung (18, 18'), die dazu ausgebildet ist, aus dem Eingangssignal oder aus einem von dem Eingangssignal abgeleiteten Signal ein gepulstes elektrisches Signal mit wenigstens einem Puls zu erzeugen, wobei die Breite (t₂) des wenigstens einen Pulses von der Spannungsamplitude (A₁) des Eingangssignals abhängt,
wobei die Vorrichtung einen gemeinsamen Mikroprozessor (30) umfasst, der dazu ausgebildet ist, die gepulsten Signale der Kanäle oder von den gepulsten Signalen abgeleitete Signale der Kanäle zu empfangen und durch Auswerten einer jeweiligen Pulsbreite der empfangenen Signale einen digitalen Wert zu erzeugen, welcher der Spannungsamplitude (A₁) des Eingangssignals des jeweiligen Kanals entspricht,
wobei zumindest ein Kanal eine Stromversorgungsschaltung (40) aufweist, welche dazu eingerichtet ist, aus dem Eingangssignal des Kanals oder aus dem von dem Eingangssignal abgeleiteten Signal des Kanals zumindest ein Gleichspannungssignal mit einer Spannung zur Stromversorgung der Komponenten des Kanals zu erzeugen.

2. Vorrichtung nach Anspruch 1,
wobei zumindest ein Kanal und insbesondere jeder Kanal eine Gleichrichterschaltung, welche insbesondere einen Brückengleichrichter (14, 14') umfasst, zur Erzeugung eines gleichgerichteten Signals aus dem Eingangssignal des Kanals oder aus einem von dem Eingangssignal abgeleiteten Signal des Kanals umfasst.

3. Vorrichtung nach Anspruch 1 oder 2,
wobei zumindest ein Kanal und insbesondere jeder Kanal eine Skalierungsschaltung zur Erzeugung eines skalierten Signals aus dem Eingangssignal des Kanals oder aus dem von dem Eingangssignal abgeleiteten Signal des Kanals aufweist, wobei die Skalierungsschaltung insbesondere einen Spannungsteiler (16, 16') umfasst.

4. Vorrichtung nach zumindest einem der vorstehenden Ansprüche, wobei die Signalverarbeitungseinrichtung (18, 18') zumindest eines Kanals und insbesondere jedes Kanals dazu eingerichtet ist, aus dem Eingangssignal des Kanals oder aus dem von dem Eingangssignal abgeleiteten Signal des Kanals ein pulsweitenmoduliertes Signal zu erzeugen, wobei die Pulsbreite (t₂) des pulsweitenmodulierten Signals von der Spannungsamplitude (A₁) des Eingangssignals abhängt.

5. Vorrichtung nach zumindest einem der vorstehenden Ansprüche, wobei die Signalverarbeitungseinrichtung zumindest eines Kanals und insbesondere jedes Kanals einen weiteren dem Kanal zugeordneten Mikroprozessor (18, 18') umfasst.

6. Vorrichtung nach zumindest einem der vorstehenden Ansprüche, wobei zumindest ein Kanal und insbesondere jeder Kanal dazu eingerichtet ist, die Spannung (U_{E}) des Eingangssignals des Kanals oder die Spannung eines von dem Eingangssignal abgeleiteten Signals des Kanals mit einem vorgegebenen Schwellwert zu vergleichen, wobei die Erzeugung des gepulsten Signals des Kanals insbesondere unterbleibt, wenn die Spannung den Schwellwert unterschreitet.

7. Vorrichtung nach zumindest einem der vorstehenden Ansprüche, wobei zwischen zumindest einem Kanal und dem gemeinsamen Mikroprozessor (30) Mittel zur nicht-galvanischen Übertragung des gepulsten Signals des Kanals oder des von dem gepulsten Signal abgeleiteten Signals des Kanals zu dem gemeinsamen Mikroprozessor (30) vorgesehen ist, welche insbesondere einen Optokoppler (20, 22) umfassen.

8. Vorrichtung nach zumindest einem der vorstehenden Ansprüche, wobei der gemeinsame Mikroprozessor (30) dazu eingerichtet ist, das gepulste Signal zumindest eines Kanals und insbesondere jedes Kanals oder das von dem jeweiligen gepulsten Signal abgeleitetes Signal so auszuwerten, dass eine steigende Flanke und/oder eine fallende Flanke eines Pulses des gepulsten Signals jeweils zu einem Interrupt in dem gemeinsamen Mikroprozessor (30) führt.

9. Vorrichtung nach zumindest einem der vorstehenden Ansprüche, wobei der gemeinsame Mikroprozessor (30) dazu eingerichtet ist, festzustellen, ob die Spannungsamplitude (A₁) des Eingangssignals eines Kanals einen bestimmten, insbesondere einstellbaren, Schwellwert übersteigt.

10. Vorrichtung nach zumindest einem der vorstehenden Ansprüche, wobei der gemeinsame Mikroprozessor (30) dazu eingerichtet ist, zum Beispiel über ein Bussystem, mit einer übergeordneten Steuerung zu kommunizieren, wobei der gemeinsame Mikroprozessor (30) vorzugsweise dazu eingerichtet ist, die durch die Auswertung der Eingangssignale gewonnenen Informationen an die übergeordnete Steuerung zu melden und/oder Steuersignale von der übergeordneten Steuerung zu empfangen.

11. Vorrichtung nach zumindest einem der vorstehenden Ansprüche, wobei wenigstens ein Ausgang vorgesehen ist, der von dem gemeinsamen Mikroprozessor (30) steuerbar ist und der vorzugsweise zumindest ein von dem gemeinsamen Mikroprozessor (30) ansteuerbares Relais (A, B, C, D, E) umfasst.

12. Vorrichtung nach Anspruch 11, wobei der wenigstens eine Ausgang von dem gemeinsamen Mikroprozessor (30) in Abhängigkeit von der Spannungsamplitude zumindest eines Eingangssignals steuerbar ist.

13. Schaltanlage für die Mittel- oder Hochspannungstechnik mit zumindest einer Vorrichtung nach zumindest einem der vorstehenden Ansprüche.

## Claims

1. An apparatus for evaluating input signals in a switchgear for medium-voltage technology or high-voltage technology, comprising a plurality of channels, wherein each channel comprises the following components:
- an input (E₁, E₂, E₁', E₂') for receiving an electrical input signal; and from the input signal or from a signal derived from the input signal
- a signal processing device (18, 18') which is configured to generate from the input signal or from a signal derived from the input signal a pulsed electrical signal having at least one pulse, with the width (t₂) of the at least one pulse depending on the voltage amplitude (A₁) of the input signal,
wherein the apparatus comprises a common microprocessor (30) which is configured to receive the pulsed signals of the channels or signals of the channels derived from the pulsed signals and to generate a digital value, which corresponds to the voltage amplitude (A₁) of the input signal of the respective channel, by evaluating a respective pulse width of the received signals; and
wherein at least one channel has a power supply circuit (40) which is adapted to generate from the input signal of the channel or from the signal of the channel derived from the input signal at least one DC voltage signal having a voltage for the power supply of the components of the channel.

2. An apparatus in accordance with claim 1,
wherein at least one channel, and in particular each channel, comprises a rectifier circuit, which in particular comprises a bridge rectifier (14, 14'), for generating a rectified signal from the input signal of the channel or from a signal of the channel derived from the input signal.

3. An apparatus in accordance with claim 1 or claim 2,
wherein at least one channel, and in particular each channel, has a scaling circuit for generating a scaled signal from the input signal of the channel or from the signal of the channel derived from the input signal, with the scaling circuit in particular comprising a voltage divider (16, 16').

4. An apparatus in accordance with at least one of the preceding claims,
wherein the signal processing device (18, 18') of at least one channel, and in particular of each channel, is adapted to generate a pulse width modulated signal from the input signal of the channel or from the signal of the channel derived from the input signal, with the pulse width (t₂) of the pulse width modulated signal depending on the voltage amplitude (A₁) of the input signal.

5. An apparatus in accordance with at least one of the preceding claims,
wherein the signal processing device of at least one channel, and in particular of each channel, comprises a further microprocessor (18, 18') associated with the channel.

6. An apparatus in accordance with at least one of the preceding claims,
wherein at least one channel, and in particular each channel, is adapted to compare the voltage (U_{E}) of the input signal of the channel or the voltage of a signal of the channel derived from the input signal with a predefined threshold value, with the generation of the pulsed signal of the channel in particular being omitted if the voltage falls below the threshold value.

7. An apparatus in accordance with at least one of the preceding claims,
wherein means for the non-galvanic transmission of the pulsed signal of the channel or of the signal of the channel derived from the pulsed signal to the common microprocessor (30) are provided between at least one channel and the common microprocessor (30) and in particular comprise an optocoupler (20, 22).

8. An apparatus in accordance with at least one of the preceding claims,
wherein the common microprocessor (30) is adapted to evaluate the pulsed signal of at least one channel, and in particular of each channel, or the signal derived from the respective pulsed signal such that a rising edge and/or a falling edge of a pulse of the pulsed signal respectively results/result in an interrupt in the common microprocessor (30).

9. An apparatus in accordance with at least one of the preceding claims,
wherein the common microprocessor (30) is adapted to determine whether the voltage amplitude (A₁) of the input signal of a channel exceeds a specific threshold value which can in particular be set.

10. An apparatus in accordance with at least one of the preceding claims,
wherein the common microprocessor (30) is adapted to communicate with a higher-ranking control, for example via a bus system, with the common microprocessor (30) preferably being adapted to report the information obtained by the evaluation of the input signals to the higher-ranking control and/or to receive control signals from the higher-ranking control.

11. An apparatus in accordance with at least one of the preceding claims,
wherein at least one output is provided which is controllable by the common microprocessor (30) and which preferably comprises at least one relay (A, B, C, D, E) controllable by the common microprocessor (30).

12. An apparatus in accordance with claim 11,
wherein the at least one output is controllable by the common microprocessor (30) in dependence on the voltage amplitude of at least one input signal.

13. A switchgear for medium-voltage technology or high-voltage technology comprising at least one apparatus in accordance with at least one of the preceding claims.

## Revendications

1. Dispositif d'évaluation de signaux d'entrée dans une installation de commutation pour la technique moyenne ou haute tension, à plusieurs canaux, chaque canal comprenant les composants suivants :
- une entrée (E₁, E₂, E₁', E₂') pour recevoir un signal électrique d'entrée, et
- un dispositif de traitement de signal (18, 18') qui est conçu pour générer un signal électrique pulsé à au moins une impulsion à partir du signal d'entrée ou d'un signal dérivé du signal d'entrée, la largeur (t₂) de ladite au moins une impulsion dépendant de l'amplitude de tension (A₁) du signal d'entrée,
le dispositif comprenant un microprocesseur commun (30) qui est conçu pour recevoir les signaux pulsés des canaux ou des signaux des canaux dérivés des signaux pulsés et pour générer une valeur numérique en évaluant une largeur d'impulsion respective des signaux reçus, laquelle valeur numérique correspond à l'amplitude de tension (A₁) du signal d'entrée du canal respectif, au moins un canal présentant un circuit d'alimentation électrique (40) qui est conçu pour générer, à partir du signal d'entrée du canal ou du signal du canal dérivé du signal d'entrée, au moins un signal de tension continue avec une tension pour l'alimentation électrique des composants du canal.

2. Dispositif selon la revendication 1,
dans lequel au moins un canal et en particulier chaque canal comprend un circuit redresseur, qui comprend en particulier un redresseur en pont (14, 14'), pour générer un signal redressé à partir du signal d'entrée du canal ou d'un signal du canal dérivé du signal d'entrée.

3. Dispositif selon la revendication 1 ou 2,
dans lequel au moins un canal et en particulier chaque canal comprend un circuit de mise à l'échelle pour générer un signal mis à l'échelle à partir du signal d'entrée du canal ou du signal du canal dérivé du signal d'entrée, le circuit de mise à l'échelle comprenant en particulier un diviseur de tension (16, 16').

4. Dispositif selon au moins l'une des revendications précédentes,
dans lequel le dispositif de traitement de signal (18, 18') d'au moins un canal et en particulier de chaque canal est conçu pour générer un signal modulé en largeur d'impulsion à partir du signal d'entrée du canal ou du signal du canal dérivé du signal d'entrée, la largeur d'impulsion (t₂) du signal modulé en largeur d'impulsion dépendant de l'amplitude de tension (A₁) du signal d'entrée.

5. Dispositif selon au moins l'une des revendications précédentes,
dans lequel le dispositif de traitement de signaux d'au moins un canal et en particulier de chaque canal comprend un autre microprocesseur (18, 18') associé au canal.

6. Dispositif selon au moins l'une des revendications précédentes,
dans lequel au moins un canal et en particulier chaque canal est conçu pour comparer la tension (U_{E}) du signal d'entrée du canal ou la tension d'un signal du canal dérivé du signal d'entrée avec une valeur seuil prédéfinie, la génération du signal pulsé du canal étant en particulier omise si la tension devient inférieure à la valeur seuil.

7. Dispositif selon au moins l'une des revendications précédentes,
dans lequel des moyens sont prévus entre au moins un canal et le microprocesseur commun (30) pour la transmission non galvanique du signal pulsé du canal ou du signal du canal dérivé du signal pulsé au microprocesseur commun (30), lesquels moyens comprennent en particulier un optocoupleur (20, 22).

8. Dispositif selon au moins l'une des revendications précédentes,
dans lequel le microprocesseur commun (30) est conçu pour évaluer le signal pulsé d'au moins un canal et en particulier de chaque canal ou le signal dérivé du signal pulsé respectif de telle sorte qu'un front montant et/ou un front descendant d'une impulsion du signal pulsé conduise à chaque fois à une interruption dans le microprocesseur commun (30).

9. Dispositif selon au moins l'une des revendications précédentes,
dans lequel le microprocesseur commun (30) est conçu pour établir si l'amplitude de tension (A₁) du signal d'entrée d'un canal dépasse une valeur seuil déterminée, en particulier réglable.

10. Dispositif selon au moins l'une des revendications précédentes,
dans lequel le microprocesseur commun (30) est conçu pour communiquer, par exemple via un système de bus, avec une commande de niveau supérieur, le microprocesseur commun (30) étant de préférence conçu pour rapporter les informations obtenues par l'évaluation des signaux d'entrée à la commande de niveau supérieur et/ou pour recevoir des signaux de commande de la commande de niveau supérieur.

11. Dispositif selon au moins l'une des revendications précédentes,
dans lequel il est prévu au moins une sortie qui peut être commandée par le microprocesseur commun (30) et qui comprend de préférence au moins un relais (A, B, C, D, E) pouvant être commandé par le microprocesseur commun (30).

12. Dispositif selon la revendication 11,
dans lequel ladite au moins une sortie peut être commandée par le microprocesseur commun (30) en fonction de l'amplitude de tension d'au moins un signal d'entrée.

13. Installation de commutation pour la technique moyenne ou haute tension comprenant au moins un dispositif selon au moins l'une des revendications précédentes.
